# EUROPÄISCHE PATENTSCHRIFT

(11) **EP 3 912 692 B1**
(45) Veröffentlichungstag und Bekanntmachung des Hinweises auf die Patenterteilung: **02.11.2022**
(21) Anmeldenummer: 21172389.5
(22) Anmeldetag: 06.05.2021
(51) Int. Cl.: A62C 31/03, A62C 3/16, A62C 31/28

(54) **VORRICHTUNG ZUR LÖSCHMITTELABGABE**
DEVICE FOR DISPENSING EXTINGUISHING AGENT
DISPOSITIF DE DISTRIBUTION D'AGENTS D'EXTINCTION

(30) Priorität: 15.05.2020 DE 102020113194
(43) Veröffentlichungstag der Anmeldung: 24.11.2021
(73) Patentinhaber: Bender GmbH & Co. KG, 35305 Grünberg (DE)
(72) Erfinder: REITZ, Julian, 35305 Grünberg (DE)
(74) Vertreter: advotec.

(56) Entgegenhaltungen:
- CN-U- 204 469 078

## Beschreibung

Die Erfindung betrifft eine Löschmittel-Abgabevorrichtung bestehend aus einem Gehäuse mit einem Leitungskanal, der von einem Löschmittel durchströmt ist, einem metallischen Haltegriff, einer Schlauchanschlusseinrichtung, einer Verstelleinrichtung zur Regulierung einer Löschmittelzufuhr mit einem Handbedienteil und aus einer Austrittsdüse.

Bei der Brandbekämpfung von unter Spannung stehenden elektrischen Anlagen und Systemen durch ein Löschmittel kann es bei unzureichendem Sicherheitsabstand zu lebensgefährlichen Situationen für die handelnde Person bedingt durch elektrischen Schlag kommen.

Zum Erzielen der Löschwirkung wird das Löschmittel mittels einer Löschmittel-Abgabevorrichtung, wie beispielsweise einem Hohlstrahlrohr mit Vorsatzdüse, in einem Sprühstrahl oder mit Druck in einem Vollstrahl auf den Brandherd abgegeben.

Aus dem Stand der Technik bekannte Löschmittel-Abgabevorrichtungen weisen ein Gehäuse auf, das einen von dem Löschmittel durchströmten Leitungskanal ausbildet (Hohlstrahlrohr). Diese Löschmittel-Abgabevorrichtungen umfassen in bekannter Weise einen metallischen Haltegriff, einlassseitig eine Schlauchanschlusseinrichtung und eine Verstelleinrichtung zur Regulierung einer Löschmittelzufuhr mit einem Handbedienteil sowie ausgangsseitig eine Austrittsdüse für die gerichtete Abgabe des Löschmittel strahl s.

Die verwendeten Löschmittel können eine elektrische Leitfähigkeit aufweisen. Insbesondere wird bei der Verwendung von Wasser als Löschmittel dies üblicherweise aus dem örtlichen Leitungsnetz oder Regenwasserzisternen entnommen. Es ist damit nicht chemisch rein und verfügt über eine messbare elektrische Leitfähigkeit.

Wird bei der Brandbekämpfung mit elektrisch leitfähigem Löschmittel ein gewisser Sicherheitsabstand unterschritten, so kann es auf Grund fehlender Tropfenbildung im Löschwasserstrahl zu einer durchgängigen elektrisch leitenden Verbindung zwischen dem unter Spannung stehenden Brandobjekt und der Löschmittel-Abgabevorrichtung kommen.

Es besteht die Gefahr, dass eine Person, welche die Löschmittel-Abgabevorrichtung an dem metallischen Haltegriff mit den Händen berührt, mit einer Spannung beaufschlagt wird, die eine lebensgefährliche Körperdurchströmung (Körperstrom) hervorrufen kann.

Ein besonderes Gefahrenpotenzial stellt die Brandbekämpfung auf dem Gebiet der Elektromobilität dar, da Kraftfahrzeuge mit Hochvolt-Elektroantrieben im Havarie-Fall bei einem Löscheinsatz auf den ersten Blick nicht als Fahrzeuge mit einer gefährdenden Bordnetzspannung erkennbar sind.

Gemäß Feuerwehrdienstvorschrift sind im Brandeinsatz bei elektrischen Anlagen bestimmte Sicherheitsabstände durch die Einsatzkräfte einzuhalten. Diese Sicherheitsabstände können jedoch nur eingehalten werden, wenn die Gefahrensituation zuvor erkannt wird.

Für die Brandbekämpfung bei Elektrofahrzeugen sind verschiedene Sicherheitsvorkehrungen für Einsatzkräfte bekannt. So sollen beispielsweise isolierte Handschuhe getragen und ein Messgerät mitgeführt werden, um zu prüfen, ob das Elektrofahrzeug unter Spannung steht. Außerdem sind Schutzanzüge und isolierte Matten vorgeschlagen worden. Aus elektrischer Sicht sind diese Maßnahmen bei der Brandbekämpfung unzureichend, da zum einen beliebig viele metallische Punkte bei dem Brandobjekt, beispielsweise bei dem deformierten Elektrofahrzeug, auf Spannung gemessen werden müssten, zum anderen besteht bei Elektrofahrzeugen die Frage nach einem Bezugspotenzial für das als ungeerdetes Stromversorgungssystem ausgeführte Bordnetz.

Auch der Einsatz von Isoliermatten erscheint bedenklich, da diese eine Scheinsicherheit herstellen und unter Feuchtigkeitseinfluss (Löschmittel) ihre Wirkung verlieren können.

Aus der CN 204469078 U ist eine Löschmittel-Abgabevorrichtung bekannt, bei welcher ein elektrischer Strom der durch den Löschstrahl fließt erkannt wird und ein Alarm ausgelöst wird.

Der vorliegenden Erfindung liegt somit die Aufgabe zu Grunde, bei der Brandbekämpfung mittels einer Löschmittel-Abgabevorrichtung die elektrische Sicherheit für die handelnde Person zu erhöhen.

Diese Aufgabe wird in Verbindung mit den Merkmalen im Oberbegriff des Anspruchs 1 dadurch gelöst, dass die Löschmittel-Abgabevorrichtung erfindungsgemäß aufweist: einen Messstromwandler, der das in dem Leitungskanal strömende Löschmittel umschließt und ein Stromsignal erzeugt, das einem in dem Löschmittel fließenden elektrischen Strom proportional ist, einen Isolatorabschnitt, der das Gehäuse in Längsausrichtung des Leitungskanals in einen Austrittsbereich mit der Austrittsdüse und einen Eintrittsbereich mit dem Handbedienteil trennt und wobei der Messstromwandler in dem Isolatorabschnitt angeordnet ist, eine in dem Austrittsbereich in der Löschmittelströmung angeordnete erste Elektrode zur Erfassung eines Löschmittelpotenzials, eine zweite Elektrode, die zur Erfassung eines Erdpotenzials in dem Eintrittsbereich an dem metallischen Haltegriff angeordnet ist, und eine Steuereinrichtung mit einer Auswerteelektronik zur Auswertung des Stromsignals und zur Auswertung einer sich zwischen dem Löschmittelpotenzial und dem Erdpotenzial auftretenden Potenzialdifferenz und mit einem von der Auswertelektronik gesteuerten elektromechanischen Antriebselement, das auf die Verstelleinrichtung wirkt.

Der Grundgedanke der vorliegenden Erfindung beruht darauf, einen in dem Löschmittel fließenden elektrischen Strom zu erfassen und auszuwerten sowie eine Potenzialdifferenz zwischen dem elektrischen Potenzial des Löschmittels und dem Erdpotenzial zu messen und zu bewerten, mit dem Ziel einen gefährlichen Körperstrom zu vermeiden.

Zur Erfassung des in dem Löschmittel fließenden elektrischen Stroms weist die Löschmittel-Abgabevorrichtung einen Messstromwandler auf, der das in dem Leitungskanal strömende Löschmittel umschließt und den in dem Löschmittel fließenden elektrischen Strom als Primärstrom erfasst. Sekundärseitig erzeugt der Messstromwandler ein Stromsignal, das dem erfassten elektrischen Strom proportional ist.

Die Löschmittel-Abgabevorrichtung weist weiter einen Isolatorabschnitt auf, der das Gehäuse in Längsrichtung des Leitungskanals in einen Austrittsbereich und einen Eintrittsbereich trennt. Der Austrittsbereich umfasst die Austrittsdüse für den Löschmittelstrahl, der Eintrittsbereich setzt sich im Wesentlichen aus dem metallischen Handgriff, der Schlauchanschlusseinrichtung und der Verstelleinrichtung mit dem Handbedienteil zusammen.

In dem Isolatorabschnitt ist der Messstromwandler angeordnet, sodass keine die Stromerfassung verfälschenden parallelen Strompfade zu dem in dem Löschmittel fließenden elektrischen Strom existieren und sichergestellt ist, dass der in dem Löschmittel fließende elektrische Strom einen definierten Stromweg durch den Messstromwandler nimmt.

Damit stellt der Messstromwandler sekundärseitig ein Stromsignal zur Verfügung, das im Hinblick auf eine mögliche lebensgefährliche Körperdurchströmung in der Auswerteelektronik ausgewertet werden kann.

Unterstützend und ergänzend zu der Strommessung ist die Bestimmung einer zwischen dem Löschmittelpotenzial und dem Erdpotenzial auftretenden Potenzialdifferenz (elektrische Spannung) durch eine Elektrodenanordnung mit einer ersten Elektrode und einer zweiten Elektrode vorgesehen. Die erste Elektrode ist in dem Austrittsbereich in der Löschmittelströmung angeordnet, die zweite Elektrode befindet sich zur Erfassung des Erdpotenzials in dem Eintrittsbereich an dem metallischen Haltegriff.

Auf diese Weise wird eine Potenzialdifferenz (Spannungsabfall) zwischen dem Löschmittelpotenzial in dem Austrittsbereich und dem Potenzial an dem metallischen Haltegriff gemessen, wobei unter Vernachlässigung der vergleichsweise niederohmigen Körperimpedanz des Menschen das Potenzial an dem metallischen Haltegriff dem Erdpotenzial entspricht.

Diese Potenzialdifferenz kann zusätzlich einen Aufschluss darüber geben, ob eine für die handelnde Person gefährliche Berührspannung existiert, die zu einer gefährdenden Körperdurchströmung führen kann.

Die Löschmittel-Abgabevorrichtung umfasst erfindungsgemäß weiterhin eine Steuereinrichtung mit einer Auswerteelektronik und mit einem elektromechanischen Antriebselement. In der Auswerteelektronik erfolgen die Auswertung des Stromsignals und die Auswertung der Potenzialdifferenz auf jeweilige Grenzwertüberschreitungen im Hinblick auf einen möglichen gefährdenden Körperstrom. Das von der Auswerteelektronik gesteuerte elektromechanische Antriebselement, beispielweise ein Elektromotor, wirkt unmittelbar auf die Verstelleinrichtung ein.

In weiterer vorteilhafter Ausgestaltung ist die Auswerteelektronik zur Ausgabe eines Alarmsignals ausgelegt, falls die Potenzialdifferenz einen Spannungsgrenzwert überschreitet.

Übersteigt die Potenzialdifferenz einen voreinstellbaren Spannungsgrenzwert, so kann durch die Auswerteelektronik ein optischer und/oder ein akustischer (Vor-) Alarm ausgelöst werden.

Weiterhin ist die Auswerteelektronik zur Steuerung des elektromechanischen Antriebselements ausgelegt, um mittels der Verstelleinrichtung eine Unterbrechung der Löschmittelzufuhr zu bewirken, falls der in dem Löschmittel fließende elektrische Strom einen Stromgrenzwert überschreitet.

Wird von der Auswerteelektronik ein in dem Löschmittel fließender elektrischer Strom festgestellt, der zu einer gefährlichen Körperdurchströmung führen könnte, wird das elektromechanische Antriebselement durch die Auswerteelektronik derart angesteuert, dass über die Verstelleinrichtung unmittelbar eine Unterbrechung der Löschmittelzufuhr erfolgt.

Weiterhin ist der Messstromwandler zur Erfassung eines Gleichstroms und eines Wechselstroms ausgeführt.

Um auch die Gefährdung durch von Gleichspannungsquellen hervorgerufene (Gleichstrom-)Körperdurchströmungen feststellen zu können, ist der Messstromwandler neben der Detektion von Wechselströmen auch zur Erfassung eines Gleichstroms ausgelegt.

Weitere vorteilhafte Ausgestaltungsmerkmale ergeben sich aus der nachfolgenden Beschreibungen und den Zeichnungen, die eine bevorzugte Ausführungsform der Erfindung anhand eines Beispiels erläutern.

Es zeigen:
- **Fig. 1**: den Einsatz einer Löschmittel-Abgabevorrichtung bei der Brandbekämpfung und
- **Fig. 2**: eine erfindungsgemäße Löschmittel-Abgabevorrichtung in schematischer Darstellung.

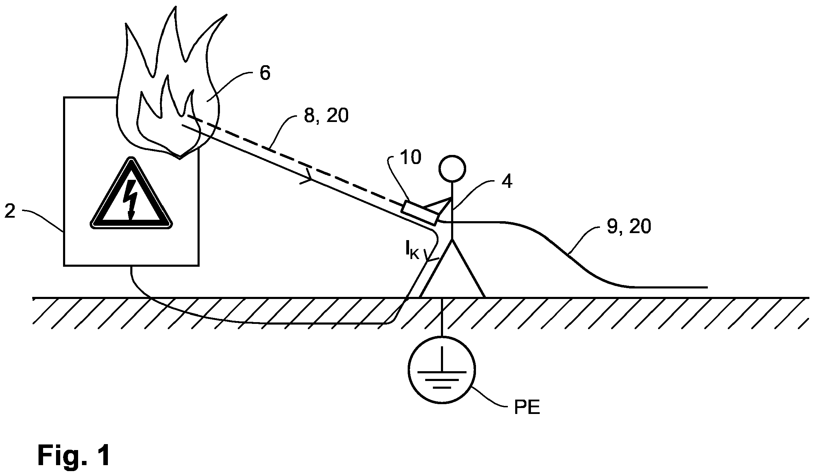

**Fig. 1** zeigt den Einsatz einer Löschmittel-Abgabevorrichtung 10 bei der Bekämpfung eines Brandherdes 6 einer elektrischen Anlage 2, beispielsweise einer Transformatorstation oder eines Elektrofahrzeugs.

Eine Einsatzkraft (handelnde Person) 4 umfasst und betätigt die Löschmittel-Abgabevorrichtung 10, wobei ein über einen Löschmittelschlauch 9 zugeführtes Löschmittel 20 in einem Löschmittelstrahl 8 auf den Brandherd 6 gerichtet wird. Aufgrund der unter Spannung stehenden elektrischen Anlage 2 kann sich über einen Löschmittelstrahl 8 in dem elektrisch leitfähigen Löschmittel 20 ein Stromfluss ausbilden, der sich als gefährliche Körperdurchströmung I_{K} über den Körper der sich auf Erdpotenzial PE befindlichen Einsatzkraft 4 fortsetzt.

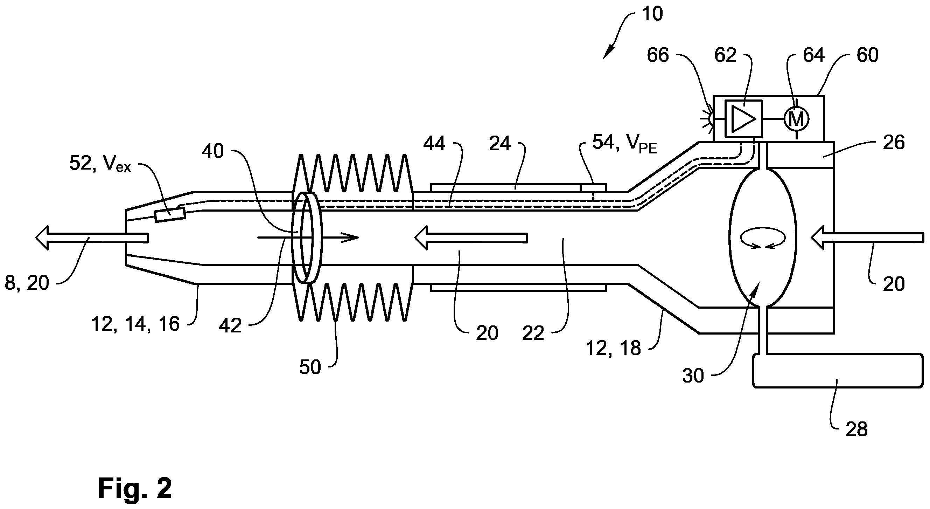

**Fig. 2** zeigt in schematischer Darstellung die erfindungsgemäße Löschmittel-Abgabevorrichtung 10.

Die erfindungsgemäße Löschmittel-Abgabevorrichtung 10 umfasst ein zweiteiliges Gehäuse 12, welches durch einen Isolatorabschnitt 50 in einen (Löschmittel-)Eintrittsbereich 18 und einen (Löschmittel-)Austrittsbereich 14 in Längsrichtung geteilt ist. Das Löschmittel 20 wird über eine Schlauchanschlusseinrichtung 26 durch einen von dem Gehäuse 12 gebildeten Leitungskanal 22 geführt und tritt an der Austrittsdüse 16 aus (Hohlstrahlrohr mit Vorsatzdüse). Über eine beispielsweise als Drosselklappe oder Kugelschieber ausgeführte Verstelleinrichtung 30 kann mittels eines Handbedienteils 28 die Löschmittelzufuhr geregelt werden.

Die Löschmittel-Abgabevorrichtung 10 umfasst einen Messstromwandler 40, der mit seinem Ringkern das in dem Leitungskanal 22 strömende Löschmittel 20 vollständig umschließt und ein Stromsignal 44 (Sekundärstrom) erzeugt, das dem in dem Löschmittel 20 fließenden elektrischen Strom 42 (Primärstrom) proportional ist.

Die Löschmittel-Abgabevorrichtung 10 umfasst weiterhin eine erste Elektrode 52, welche zur Erfassung eines Löschmittelpotenzials Vₑₓ im Austrittsbereich 14 in der Löschmittelströmung angeordnet ist. Erfindungsgemäß ist eine zweite Elektrode 54 an dem metallischen Haltegriff 24 in dem Eintrittsbereich 18 zur Erfassung eines Erdpotenzials V_{PE} als Bezugspotenzial angeordnet.

Das Stromsignal 44 des Messstromwandlers 40 sowie das von der ersten Elektrode 52 erfasste Löschmittelpotenzial Vₑₓ und das von der zweiten Elektrode 54 erfasste Erdpotenzial V_{PE} werden an eine Auswerteelektronik 62 einer Steuereinrichtung 60 weitergeleitet. Übersteigt die Potenzialdifferenz U_{d} zwischen dem Löschmittelpotenzial Vₑₓ und dem Erdpotenzial V_{PE} einen Spannungsgrenzwert, so wird dies von der Auswerteelektronik 62 erkannt, welche daraufhin ein Alarmsignal 66 optisch und/oder akustisch ausgibt.

Die Steuereinrichtung 60 umfasst weiterhin ein elektromechanisches Antriebselement 64, welches von der Auswerteelektronik 62 angesteuert wird und über die Verstelleinrichtung 30 eine Unterbrechung der Löschmittelzufuhr bewirkt, falls der in dem Löschmittel 20 fließende elektrische Strom 42 einen vorgegebenen Stromgrenzwert überschreitet.

Mit der erfindungsgemäßen Löschmittel-Abgabevorrichtung 10 ist die Maßnahme zur wirksamen Brandbekämpfung durch ein Löschmittel 20 mit Schutzmaßnahmen zur elektrischen Sicherheit gegen elektrischen Schlag vorteilhaft kombiniert worden. Es ergibt sich damit eine erhöhte elektrische Sicherheit für Einsatzkräfte 4 bei dem Löscheinsatz an elektrischen Anlagen 2. Zudem erlaubt die erfindungsgemäße Löschmittel-Abgabevorrichtung 10 eine Verringerung der vorgeschriebenen Sicherheitsabstände und damit eine effektivere Brandbekämpfung.

## Patentansprüche

1. Löschmittel-Abgabevorrichtung (10) bestehend aus einem Gehäuse (12) mit einem Leitungskanal (22), der von einem Löschmittel (20) durchströmt ist, einem metallischen Haltegriff (24), einer Schlauchanschlusseinrichtung (26), einer Verstelleinrichtung (30) zur Regulierung einer Löschmittelzufuhr mit einem Handbedienteil (28) und aus einer Austrittsdüse (16),
**gekennzeichnet durch**
einen Messstromwandler (40), der das in dem Leitungskanal (22) strömende Löschmittel (20) umschließt und ein Stromsignal (44) erzeugt, das einem in dem Löschmittel (20) fließenden elektrischen Strom (42) proportional ist,
einen Isolatorabschnitt (50), der das Gehäuse (12) in Längsausrichtung des Leitungskanals (22) in einen Austrittsbereich (14) mit der Austrittsdüse (16) und einen Eintrittsbereich (18) mit dem Handbedienteil (28) trennt und wobei der Messstromwandler (40) in dem Isolatorabschnitt (50) angeordnet ist,
eine in dem Austrittsbereich (14) in der Löschmittelströmung angeordnete erste Elektrode (52) zur Erfassung eines Löschmittelpotenzials (Vₑₓ),
eine zweite Elektrode (54), die zur Erfassung eines Erdpotenzials (V_{PE}) in dem Eintrittsbereich (18) an dem metallischen Haltegriff (24) angeordnet ist,
und eine Steuereinrichtung (60) mit einer Auswerteelektronik (62) zur Auswertung des Stromsignals (44) und zur Auswertung einer sich zwischen dem Löschmittelpotenzial (Vₑₓ) und dem Erdpotenzial (V_{PE}) auftretenden Potenzialdifferenz (U_{d}) und mit einem von der Auswertelektronik (62) gesteuerten elektromechanischen Antriebselement (64), das auf die Verstelleinrichtung (30) wirkt.

2. Löschmittel-Abgabevorrichtung (10) nach Anspruch 1,
**dadurch gekennzeichnet,**
**dass** die Auswerteelektronik (62) zur Ausgabe eines Alarmsignals (66) ausgelegt ist, falls die Potenzialdifferenz (U_{d}) einen Spannungsgrenzwert überschreitet.

3. Löschmittel-Abgabevorrichtung (10) nach Anspruch 1 oder 2,
**dadurch gekennzeichnet,**
**dass** die Auswerteelektronik (62) zur Steuerung des elektromechanischen Antriebselements (64) ausgelegt ist, um mittels der Verstelleinrichtung (30) eine Unterbrechung der Löschmittelzufuhr zu bewirken, falls der in dem Löschmittel (20) fließende elektrische Strom (42) einen Stromgrenzwert überschreitet.

4. Löschmittel-Abgabevorrichtung (10) nach einem der Ansprüche 1 bis 3,
**dadurch gekennzeichnet,**
**dass** der Messstromwandler (40) zur Erfassung eines Gleichstroms und eines Wechselstroms ausgeführt ist.

## Claims

1. An extinguishing-agent discharge device (10) consisting of a casing (12) having a guide channel (22) through which an extinguishing agent (20) flows, a metallic handle (24), a hose connection means (26), an adjustment means (30) for regulating an extinguishing-agent supply using a manual control unit (28) and a discharge nozzle (16),
**characterized by**
a measuring-current transformer (40) which encloses the extinguishing agent (20) flowing in the guide channel (22) and generates a current signal (44) which is proportional to an electric current (42) flowing in the extinguishing agent (20),
an insulator section (50) which divides the casing (12) in the longitudinal direction of the guide channel (22) into a discharge area (14) having the discharge nozzle (16) and an inlet area (18) having the manual control unit (28), the measuring-current transformer (40) being disposed in the insulator section (50),
a first electrode (52) which is disposed in the discharge area (14) in the extinguishing-agent flow and serves for detecting an extinguishing-agent potential (Vₑₓ),
a second electrode (54) which is disposed at the metallic handle (24) for detecting a ground potential (V_{PE}) in the inlet area (18), and a control device (60) having evaluation electronics (62) for evaluating the current signal (44) and for evaluating a potential difference (Ud) occurring between the extinguishing-agent potential (Vₑₓ) and ground potential (V_{PE}) and having a drive element (64) which is controlled by the evaluation electronics (62) and acts on the adjustment means (30).

2. The extinguishing-agent discharge device (10) according to claim 1,
**characterized in that**
the evaluation electronics (62) are configured for outputting an alarm signal (66) if the potential difference (Ud) exceeds a voltage threshold.

3. The extinguishing-agent discharge device (10) according to claim 1 or 2,
**characterized in that**
the evaluation electronics (62) are configured for controlling the electromechanical drive element (64) in order to cause an interruption in the extinguishing-agent supply by means of the adjustment means (30) if the electric current (42) flowing in the extinguishing agent (20) exceeds a current threshold.

4. The extinguishing-agent discharge device (10) according to any one of the claims 1 to 3,
**characterized in that**
the measuring-current transformer (40) is configured for detecting a direct current and an alternating current.

## Revendications

1. Distributeur (10) d'agent extincteur consistant en un boîtier (12) ayant une gaine (22) par laquelle un agent extincteur (20) écoule, une poignée (24) métallique, un moyen (26) de raccord de tuyau, un moyen d'ajustement (30) pour réguler une alimentation en agent extincteur en utilisant une unité (28) de contrôle manuelle et une buse de distribution (16),
**caractérisé par**
un transformateur (40) de courant pour mesures qui encercle l'agent extincteur (20) s'écoulant dans la gaine (22) et qui génère un signal de courant (44) qui est proportionnel à un courant électrique (42) s'écoulant dans l'agent extincteur (20),
une partie d'isolant (50) qui divise le boîtier (12) en longueur de la gaine (22) dans une partie de sortie (14) ayant la buse de sortie (16) et une partie d'entrée (18) ayant l'unité de control manuelle (28), le transformateur (40) de courant pour mesures étant disposé dans la partie d'isolant (50),
une première électrode (52) qui est disposée dans la partie de sortie (14) dans l'écoulement d'agent extincteur et qui sert à détecter un potentiel d'agent extincteur (Vₑₓ),
une deuxième électrode (54) qui est disposée sur la poignée (24) métallique pour détecter un potentiel de terre (V_{PE}) dans la partie d'entrée (18),
et un dispositif de commande (60) ayant un dispositif (62) de détection électronique pour évaluer le signal de courant (44) et pour évaluer une différence de potentiel (Ud) se passant entre le potentiel d'agent extincteur (Vₑₓ) et le potentiel de terre (V_{PE}) et ayant un élément d'entraînement (64) qui est commandé par le dispositif (62) de détection électronique et qui agit sur le moyen d'ajustement (30).

2. Distributeur (10) d'agent extincteur selon la revendication 1,
**caractérisé en ce que**
le dispositif (62) de détection électronique est conçu pour sortir un signal d'alarme (66) si la différence de potentiel (Ud) surpasse un seuil de tension.

3. Distributeur (10) d'agent extincteur selon la revendication 1 ou la revendication 2,
**caractérisé en ce que**
le dispositif (62) de détection électronique est conçu pour commander l'élément d'entraînement (64) électromécanique afin de causer une interruption dans l'alimentation en agent extincteur au moyen du moyen d'ajustement (30) si le courant électrique (42) écoulant dans l'agent extincteur (20) surpasse un seuil de courant.

4. Distributeur (10) d'agent extincteur selon l'une quelconque des revendications 1 à 3,
**caractérisé en ce que**
le transformateur (40) de courant pour mesures est conçu pour détecter un courant continu et un courant alternatif.
